# EUROPEAN PATENT APPLICATION

(11) **EP 4 738 063 A1**
(43) Date of publication of application: **06.05.2026**
(21) Application number: 25209095.6
(22) Date of filing: 16.10.2025
(51) Int. Cl.: G06F 1/20, H05K 7/20, H10W 40/22

(54) **SERVER**

(30) Priority: 05.11.2024 CN 202411571586
(71) Applicant: Delta Electronics (Shanghai) Co., Ltd., Shanghai 201209 (CN)
(72) Inventor: LI, Yingjue, SHANGHAI, 201209 (CN); ZHAO, Jie, SHANGHAI, 201209 (CN); LIANG, Le, SHANGHAI, 201209 (CN); ZHOU, Min, SHANGHAI, 201209 (CN)
(74) Representative: Cabinet Beau de Loménie

(57) **Abstract**

The present disclosure relates to the technical field of electronic power, and in particular to a server, which includes a data processing apparatus and a first heatsink, the data processing apparatus includes a load group and a power supply module group, the load group includes at least two loads, and the power supply module group supplies power to the loads; the first heatsink is thermally connected to the power supply module group, at least part of a projection of the first heatsink in a first plane is located outside a load region, the first plane is parallel to an upper surface of the load, the load region is a minimum outer contour projection region of the load group that can cover all loads in the first plane.

## Description

### TECHNICAL FIELD

The present disclosure relates to the technical field of electronic power, and in particular, to a server.

### BACKGROUND

With the demand for high computing power in the artificial intelligence and cloud computing industries, the power supply system will be oriented towards kilowatt-class chips. The power supply architectures used in existing servers mainly include horizontal power supply architecture and vertical power supply architecture. In the horizontal power supply scheme, the transmission path of the current through the circuit board is long, the Power Delivery Network (PDN) has large losses, and the system power supply efficiency is low. In the vertical power supply scheme, the heatsink used to dissipate heat from the power supply module group will occupy the heat dissipation space of the load, and the heat dissipation capacity of the load is limited, affecting its computing power. At the same time, the heatsink of the rear power supply module group is affected by the front load heatsink, resulting in poor heat dissipation capacity and being unable to meet the heat dissipation requirement of the power supply module group.

### SUMMARY

The present disclosure provides a server, including a data processing apparatus and a first heatsink, the data processing apparatus includes a load group and a power supply module group, the load group includes at least two loads, and the power supply module group supplies power to the load group; the first heatsink is thermally connected to the power supply module group, and at least part of a projection of the first heatsink in a first plane is located outside a load region, where the load includes an upper surface and a lower surface arranged oppositely, the first plane is parallel to the upper surface of the load, and the load region is a minimum outer contour projection region of the load group that can cover all the loads in the first plane.

In one embodiment of the present disclosure, at least 10% of the projection of the first heatsink in the first plane is located outside the load region.

In one embodiment of the present disclosure, the part of the first heatsink located outside the load region is distributed outside at least two edges of the load region.

In one embodiment of the present disclosure, the server further includes a housing and a second heatsink, the second heatsink is located above the load and is used to dissipate heat from the load; the first heatsink, the second heatsink and the load group are all located in the housing; in the projection in the first plane, at least part of the first heatsink is located between a side wall of the housing and a side wall of the second heatsink arranged opposite to the side wall of the housing, and a width of the part of the first heatsink located between the side wall of the housing and the side wall of the second heatsink is at least 10% of a distance between the side wall of the second heatsink and the side wall of the housing.

In one embodiment of the present disclosure, at least part of the first heatsink is in contact with the housing.

In one embodiment of the present disclosure, the power supply module group includes at least one power supply submodule group, and a third heatsink is provided on both sides of the second heatsink, the third heatsink includes a third heat conduction portion and a third heat dissipation portion, the third heat conduction portion is thermally connected to the power supply module group, the third heat dissipation portion is thermally connected to the third heat conduction portion, and at least part of a projection of the third heatsink in the first plane is located in the load region.

In one embodiment of the present disclosure, the third heatsink is a wind scooper structure, the power supply submodule group is thermally connected to the wind scooper, and the wind scooper is arranged around a circumference of the power supply submodule group.

In one embodiment of the present disclosure, the data processing apparatus further includes a first carrier board, and the power supply module group supplies power to the load group through the first carrier board;
the first carrier board is arranged between the load group and the power supply module group, or the load group and the power supply module group are arranged on a same side of the first carrier board;
at least part of the first heatsink is located at a side of the power supply module group away from the first carrier board.

In one embodiment of the present disclosure, a projection region of the first carrier board in the first plane is larger than the load region, and at least part of the projection of the first heatsink in the first plane is located between the load region and the projection region of the first carrier board in the first plane; or, at least part of the projection of the first heatsink in the first plane is located outside the projection region of the first carrier board in the first plane.

In one embodiment of the present disclosure, the first carrier board includes at least two subcarrier boards, the at least two subcarrier boards are respectively connected to the at least two loads in the load group, the power supply module group includes at least two power supply submodule groups, the at least two power supply submodule groups are respectively connected to the at least two subcarrier boards, and a projection region of the first carrier board in the first plane is a minimum outer contour projection region of the first carrier board that can cover all the subcarrier boards in the first plane.

In one embodiment of the present disclosure, the projection region of the first carrier board in the first plane is used as the load region.

In one embodiment of the present disclosure, the server further includes a housing, at least part of the first heatsink is located between the housing and an edge of the first carrier board, and a width of the part of the first heatsink located between the housing and the edge of the first carrier board is at least 10% of a distance between the edge of the first carrier board and the side wall of the housing arranged opposite to the edge.

In one embodiment of the present disclosure, the server further includes a second carrier board, the second carrier board is located below the first carrier board, and at least part of the first heatsink is located above the second carrier board.

In one embodiment of the present disclosure, the first heatsink includes a first heat conduction portion, the second carrier board is provided with a first through hole, the first heat conduction portion includes a first protrusion, and the first protrusion is inserted in the first through hole to dissipate heat for the power supply module group.

In one embodiment of the present disclosure, the first heatsink includes a first heat dissipation portion, and the first heat dissipation portion is entirely arranged below the second carrier board.

In one embodiment of the present disclosure, the server further includes an additional heat source and a fourth heatsink, and the additional heat source is arranged on the second carrier board;
the second carrier board is provided with a second through hole, the fourth heatsink includes a second protrusion, and the second protrusion is inserted in the second through hole and is thermally connected to the additional heat source;
and/or, the second carrier board is provided with a third through hole, a heat conduction column is arranged in the third through hole, and the additional heat source is thermally connected to the fourth heatsink through the heat conduction column.

In one embodiment of the present disclosure, the server further includes a second carrier board, the load group and the power supply module group are both arranged on a same side of the second carrier board, and the first heatsink is located above the power supply module group.

In one embodiment of the present disclosure, the power supply module group includes at least one power supply submodule group, the first heatsink includes a first heat conduction portion and a first heat dissipation portion, at least part of the first heat conduction portion is arranged below the power supply module group, at least part of the first heat dissipation portion is located outside the load region, and the first heat dissipation portion is thermally connected to the first heat conduction portion.

In one embodiment of the present disclosure, the first heatsink is a wind scooper structure, the power supply submodule group is thermally connected to the wind scooper, and the wind scooper is arranged around a circumference of the power supply submodule group.

In one embodiment of the present disclosure, the first heat conduction portion includes one or more of a heat pipe, a vapor chamber, a metal heat conduction plate, and a non-metallic heat conduction structure.

In one embodiment of the present disclosure, the first heat dissipation portion includes one or more of a heat dissipation fin, a liquid-cooled plate, a metal plate, and a non-metallic heat dissipation structure.

In one embodiment of the present disclosure, the first heatsink is an integrated structure, or the first heatsink includes multiple heat dissipation structures, and the multiple heat dissipation structures are connected.

In one embodiment of the present disclosure, the load includes one or more of a GPU, a CPU, a NPU, a DPU, an ASIC, an FPGA, an APU, or a TPU.

In one embodiment of the present disclosure, a number of the data processing apparatus is at least two, the at least two data processing apparatuses are arranged along a first direction, the at least two loads in the load group in each of the data processing apparatuses are arranged along a second direction, the first direction is perpendicular to the second direction, and the first direction and the second direction are both parallel to the first plane.

In one embodiment of the present disclosure, the data processing apparatus is an open computing accelerator module.

In one embodiment of the present disclosure, the power supply module group includes at least one power supply submodule group, and the power supply submodule group includes at least one power supply assembly.

### BRIEF DESCRIPTION OF THE DRAWINGS

In order to more clearly illustrate the specific embodiments of the present disclosure or the technical solutions in the related art, the drawings required to be used in the description of the specific embodiments or the related art will be briefly introduced below. Obviously, the drawings in the following description are some embodiments of the present disclosure. For those skilled in the art, other drawings can also be obtained based on these drawings without creative work.
FIG. 1 is a structural diagram of a server provided in an embodiment of the present disclosure;
FIG. 2 is a schematic diagram of a load region in an embodiment of the present disclosure;
FIG. 3 is another structural diagram of the server provided in an embodiment of the present disclosure;
FIG. 4 is a third structural diagram of the server provided in an embodiment of the present disclosure;
FIG. 5 is a fourth structural diagram of the server provided in an embodiment of the present disclosure;
FIG. 6 is a fifth structural diagram of the server provided in an embodiment of the present disclosure;
FIG. 7 is a sixth structural diagram of the server provided in an embodiment of the present disclosure;
FIG. 8 is a seventh structural diagram of the server provided in an embodiment of the present disclosure;
FIG. 9 is an eighth structural diagram of the server provided in an embodiment of the present disclosure;
FIG. 10 is a structural diagram of a third heatsink in a server provided in an embodiment of the present disclosure;
FIG. 11 is another structural diagram of the third heatsink in the server provided in an embodiment of the present disclosure;
FIG. 12 is a ninth structural diagram of the server provided in an embodiment of the present disclosure;
FIG. 13 is a tenth structural diagram of the server provided in an embodiment of the present disclosure;
FIG. 14 is a schematic diagram of a carrier board region in an embodiment of the present disclosure;
FIG. 15 is an eleventh structural diagram of the server provided by the embodiment of the present disclosure;
FIG. 16 is a twelfth structural diagram of the server provided by the embodiment of the present disclosure;
FIG. 17 is a thirteenth structural diagram of the server provided by the embodiment of the present disclosure;
FIG. 18 is a fourteenth structural diagram of the server provided by the embodiment of the present disclosure;
FIG. 19 is a fifteenth structural diagram of the server provided by the embodiment of the present disclosure;
FIG. 20 is a sixteenth structural diagram of the server provided by the embodiment of the present disclosure;
FIG. 21 is a seventeenth structural diagram of the server provided by the embodiment of the present disclosure;
FIG. 22 is a top view of the server provided by an embodiment of the present disclosure (the number of data processing apparatuses is multiple);
FIG. 23 is another top view of the server provided by an embodiment of the present disclosure (the number of data processing apparatuses is multiple);
FIG. 24 is an eighteenth structural diagram of the server provided by the embodiment of the present disclosure;
FIG. 25 is a nineteenth structural diagram of the server provided by the embodiment of the present disclosure;
FIG. 26 is a twentieth structural diagram of the server provided by the embodiment of the present disclosure.

The reference signs are as follows:
1-Load; 2-Power supply submodule group; 21-Power supply module; 3-First heatsink; 31-First heat conduction portion; 311-First protrusion; 312-Heat conduction plate; 313-Vapor chamber; 32-First heat dissipation portion; 3a-First heat dissipation structure; 3b-Second heat dissipation structure; 4-Second heatsink; 5-Housing; 51-Bottom plate; 52-Side wall; 6-Third heatsink; 61-Third heat conduction portion; 611-U-shaped heat pipe; 62-Third heat dissipation portion; 621-U-shaped plate; 7-Subcarrier board; 71-First reinforcing rib; 72-Second reinforcing rib; 8-Second carrier board; 81-Heat conduction column; 9-Fourth heatsink; 91-Second protrusion; 10-Additional heat source; 20-System support plate.

### DETAILED DESCRIPTION

The technical solutions of the present disclosure will be described clearly and completely in conjunction with the embodiments below. Obviously, the described embodiments are part of the embodiments of the present disclosure, not all of the embodiments. Based on the embodiments in the present disclosure, all other embodiments obtained by those skilled in the art without creative work are within the scope of protection of the present disclosure.

In the description of the present disclosure, it should be noted that if the terms "center", "above", "below", "left", "right", "vertical", "horizontal", "inside", "outside", etc. appear, the orientation or position relationship indicated is based on the orientation or position relationship shown in the accompanying drawings, which is only for the convenience of describing the present disclosure and simplifying the description, rather than indicating or implying that the apparatus or element referred to must have a specific orientation, be constructed and operated in a specific orientation, and therefore cannot be understood as a limitation on the present disclosure. In addition, if the terms "first", "second", and "third" appear, they are only used for descriptive purposes and cannot be understood as indicating or implying relative importance.

In the description of the present disclosure, it should be noted that, unless otherwise clearly specified and limited, the terms "install", "link", and "connect" should be understood in a broad sense, for example, it can be a fixed connection, a detachable connection, or an integral connection; it can be a mechanical connection or an electrical connection; it can be direct connection, or indirect connection through an intermediate medium, or it can be the internal communication of two elements. For those skilled in the art, the specific meanings of the above terms in the present disclosure can be understood according to specific circumstances.

After long-term observation, experiment and research, the inventor found that the main reasons for the poor heat dissipation performance of the power supply module in the existing server are as follows. Taking a case of a vertical power supply architecture as an example, the internal structure of a general Artificial Intelligence (AI) server is explained. In more common cases, the AI server contains a system board and multiple Open Computing Project Accelerator Module (OAM) module groups arranged on the system board, and a single OAM module group mainly includes an OAM board, a load, a load heatsink and a power supply module group, and the electrical signal transmission between the system board and the single OAM board is realized through a connector. The power supply module group is arranged on the bottom surface of the OAM board or is indirectly electrically connected to the bottom surface of the OAM board through a carrier board, the load is arranged on the top surface of the OAM board, the projections of the power supply module group and the load on the plane where the system board is located at least partially overlap, and the power supply module group supplies power to the load. In order to prevent the OAM board from warping and deformation, reinforcing ribs are usually arranged on the top and bottom surfaces of the OAM board respectively. The existing heat dissipation scheme of the OAM module group is an on-board heat dissipation scheme based on a single OAM module group, and the load heatsink of a single load in each OAM module group is located above the OAM board of the OAM module group (above the load), and when the reinforcing rib is provided on the top surface, the load heatsink is located above the reinforcing rib. The maximum on-board heat dissipation space of a single OAM module group is above the OAM board of the OAM module group, and in the space where the projection of the system board overlaps with the projection of the OAM board on the system board. The load heatsink is located in the maximum on-board heat dissipation space. The projection of the load heatsink on the plane where the system board is located at least covers the projection of the corresponding load on the plane where the system board is located, that is, the load heatsink is provided directly above the load, which can increase the heat dissipation area of the load heatsink. The heatsink is provided vertically to the load, which can shorten the heat dissipation path to the greatest extent, thereby improving the heat dissipation capacity of the load heatsink. In order to achieve the high computing power requirement of the load, the load heatsink is often set as large as possible to meet the high power consumption requirement. Therefore, the load heatsink is usually set to occupy the maximum on-board heat dissipation space as much as possible, that is, its projection on the system board overlaps with the projection of the OAM board on the system board as much as possible.

In the heat dissipation scheme of the server based on the above power supply architecture, a set of heatsinks is often set for each single load of each OAM module group and its corresponding power supply module group. In some cases, a single load and its corresponding power supply module group are both cooled by the load heatsink, that is, the load heatsink is shared. The load heatsink is located in the maximum on-board heat dissipation space, and needs to dissipate heat from the load and the power supply module group at the same time. The maximum on-board heat dissipation space is limited by the size of the OAM board. In the maximum on-board heat dissipation space, part of the space is used to dissipate heat for the power supply module group, and the space left for heat dissipation of the load is smaller than the maximum on-board heat dissipation space, resulting in limited heat dissipation capacity of the load. In some other cases, a single load is set with a load heatsink, and the power supply module group corresponding to the single load is set with a power supply module group heatsink. The load heatsink and the power supply module group heatsink are both located in the maximum on-board heat dissipation space above the load. The maximum on-board heat dissipation space is partially occupied by the power supply module group heatsink, which will also cause the space used for heat dissipation of the load to be smaller than the maximum on-board heat dissipation space, so that the heat dissipation capacity of the load is limited, affecting its computing power. The heat dissipation areas of the load heatsink and the power supply module group heatsink restrict each other, and the heat dissipation capacities of the load heatsink and the power supply module group heatsink conflict with each other. In addition, each power supply module group corresponding to a single load is equipped with one heatsink, which also has the disadvantages of a large number of heatsinks and complex processing and installation.

Moreover, the server generally contains multiple OAM module groups, that is, it contains multiple loads and their corresponding power supply module groups. The heatsinks of individual loads and the heatsinks of the power supply module groups are alternately arranged above the load, and the load heat dissipation space and the power supply module group heat dissipation space are mixed and not independent of each other, that is, the power supply module group and the load cannot be separated for heat dissipation, resulting in low heat dissipation efficiency of the server system, limited heat dissipation capacity of the load, and insufficient heat dissipation capacity of the power supply module group, thereby causing the temperature to exceed its temperature limit requirement. At the same time, due to the width limitation of the server, the multiple OAM module groups contained in the server, that is, multiple loads and their corresponding power supply module groups are often arranged in at least two rows in front and back. After the cooling medium such as air flows in from the front, it first passes through the load heatsink and power supply module group heatsink in the first row in front, and then continues to flow into the load heatsink and power supply module group heatsink in the second row. Since the heatsinks of each load and power supply module group are located in the maximum on-board heat dissipation space of their respective OAM module groups, the maximum on-board heat dissipation space of the front and rear OAM module groups overlap in the inflow direction of the cooling medium. The load heatsink of the front OAM module group preheats the air, making the temperature of the air flowing into the power supply module group heatsink of the rear OAM module group higher, resulting in poor heat dissipation capacity of the power supply module group heatsink of the rear OAM module group. The temperature of the rear power supply module group exceeds its temperature limit requirement, and the temperature difference between the power supply module groups in the front and rear OAM module groups is large, thereby reducing the reliability and life of the power supply module group.

The purpose of the present disclosure is to provide a server to meet the heat dissipation requirement of the power supply module group and improve the performance of the server.

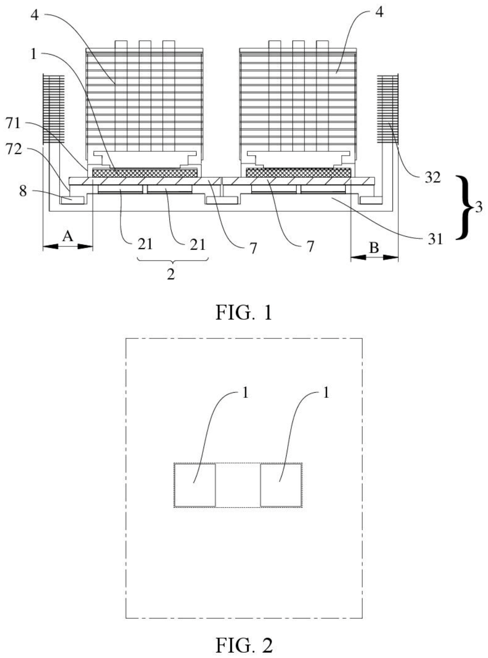

As shown in FIGs. 1 to 26, some embodiments of the present application provide a server, including a data processing apparatus, a first heatsink 3, a second carrier board 8, and a second heatsink 4. The data processing apparatus includes a load group, a power supply module group and a first carrier board. The load group includes at least two loads 1, and each load 1 includes an upper surface and a lower surface arranged opposite to each other. The power supply module group includes at least two power supply submodule groups 2. The first carrier board includes at least two subcarrier boards 7, each power supply submodule group 2 is electrically connected to a load 1 through a subcarrier board 7 to supply power to the load 1, the power supply submodule groups 2 and the loads 1 are the same in number and correspond one to one, and the power supply submodule group 2 includes at least two power supply modules 21. There is a first plane, the first plane is parallel to the upper surface of the load 1, and the lower surface of the load 1 is used for electrical connection. For example, when the power is supplied vertically, the lower surface of the load 1 can be directly connected to the power supply submodule group 2 or connected to the power supply submodule group 2 through the subcarrier board 7. For another example, when the power is supplied horizontally, the lower surface of the load 1 is connected to the first carrier board or the second carrier board 8. In a vertical system, the first plane may be a horizontal plane, and in a horizontal system, the first plane may be a vertical plane. In some embodiments of the present application, the load group and the power supply submodule group 2 adopt a vertical power supply architecture, and the load 1 and the power supply submodule group 2 are vertically stacked through a carrier board, that is, in a direction perpendicular to the first plane, i.e., in the vertical direction, the load 1 is above the power supply submodule group 2. The projections of the power supply submodule group 2 and the load 1 on the first plane at least partially overlap. Two second heatsinks 4 are respectively located above the two loads 1, and their projections on the first plane respectively cover the projections of the loads 1 on the first plane, and are located within the projection of the subcarrier 7 on the first plane. The second heatsink 4 is used to dissipate heat from the load 1, and the second heatsink 4 and the load 1 are thermally connected, and the second heatsink 4 and the load 1 are in a one-to-one correspondence. Multiple loads 1 may be connected by electrical signals through the second carrier board 8. The top and bottom surfaces of each subcarrier board 7 of the first carrier board may be respectively provided with a first reinforcing rib 71 and a second reinforcing rib 72, which play a structural support role for respective subcarrier boards 7 to prevent respective subcarrier boards 7 from warping and deformation.

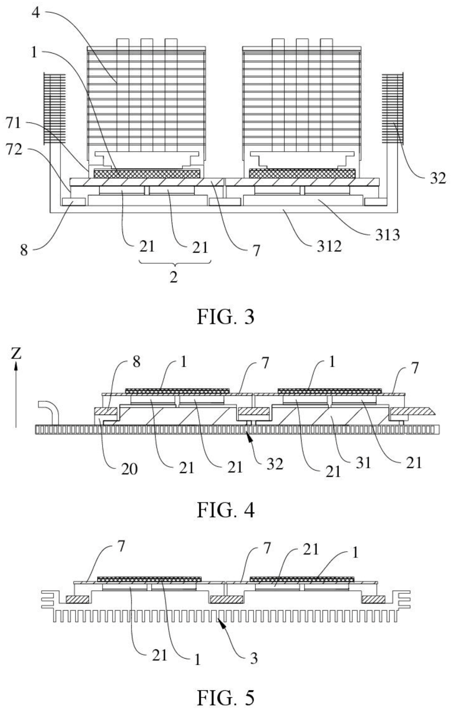

The power supply module groups (e.g., four power supply modules 21 in the FIG. 1) corresponding to the load group (e.g., two loads 1 in the FIG. 1) share one first heatsink 3, and the first heatsink 3 includes a first heat conduction portion 31 and a first heat dissipation portion 32. The server further includes a system support plate 20, which is a structural member with a certain strength and may be made of metal material or non-metal material. The first heat conduction portion 31 may be partially embedded in the system support plate 20 (as shown in FIGs. 4, 13 and 17), or it may completely replace the system support plate 20 (as shown in FIG. 1). The system support plate 20 is located below the second carrier board 8 and is mechanically connected to the second carrier board 8 to play a structural support role to prevent the second carrier board 8 from bending and deforming.

At least part of the first heat conduction portion 31 is arranged below the power supply submodule group 2 and extends to the outer side of the second carrier board 8 through the lower part of the second carrier board 8. In some embodiments of the present application, the first heat dissipation portions 32 are located outside the load region, where the load region is a projection region of a region surrounded by the minimum outer contour that can cover all loads 1 in the load group on the first plane. In some other embodiments of the present application, the projection of the first heat dissipation portions 32 on the first plane is entirely outside the projection of the subcarrier board 7 on the first plane. In this way, the first heatsink 3 is located outside the maximum on-board heat dissipation space of the OAM module group, and the maximum on-board heat dissipation space can be entirely used as the heat dissipation space of the loads 1. The first heatsink 3 does not occupy the heat dissipation space of the loads 1, and the area of the second heatsink 4 reaches the maximum, and the heat dissipation capacity of the second heatsink 4 reaches the maximum, so that the computing power performance of the load 1 can be optimum. Moreover, the heat dissipation space of the power supply module group and the heat dissipation space of the loads 1 do not intersect, and are completely independent of each other, thereby improving the heat dissipation efficiency of the server system and improving the heat dissipation capacity of the loads 1 and the power supply module group. This implementation case is suitable for situations where the load power consumption is extremely large, the power supply module group loss is small, the load temperature is so high that it limits system performance, and the load heat dissipation is the bottleneck of the system heat dissipation. In some embodiments of the present application, the two first heat dissipation portions 32 are both fins, which are respectively arranged on the left and right outer sides of the second carrier board 8, and the first heat dissipation portions 32 are thermally connected to the first heat conduction portion 31. The upper surfaces of the two power supply submodule groups 2 are respectively connected to a load 1 through a subcarrier board 7, and the lower surfaces of the two power supply submodule groups 2 are thermally connected to the first heat conduction portion 31 of a first heatsink 3, and the two power supply submodule groups 2 share the first heatsink 3 for heat dissipation. The thermal connection may refer to direct contact heat conduction connection, or indirect contact heat conduction connection through thermal interface material.

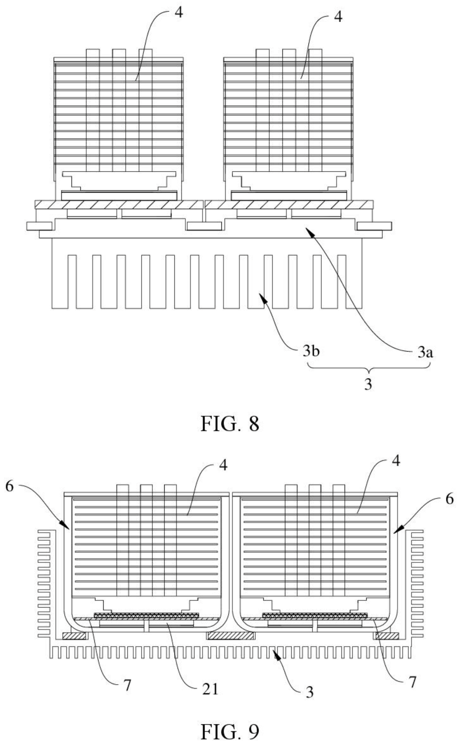

In some embodiments of the present application, the projection of the second heatsink 4 of the load 1 on the first plane is located within the projection of the subcarrier board 7 on the first plane, and the projection of the first heat dissipation portion 32 of the first heatsink 3 of the power supply submodule group 2 on the first plane is located outside the projection of the subcarrier board 7 on the first plane. The power supply submodule group 2 and the load 1 do not share the space region directly above the subcarrier board 7 (OAM board) for heat dissipation. Therefore, the power supply submodule group 2 does not occupy the heat dissipation space of the load 1, and more heat dissipation space can be created for the load 1. The heat dissipation capabilities of the first heatsink 3 and the second heatsink 4 do not conflict, ensuring that the heat dissipation effect of the load 1 is good, thereby ensuring the computing power performance of the load 1, and then improving the performance of the server. Moreover, as shown in FIGs. 1 and 9, the projections of the second heatsinks 4 on the first plane are respectively located in the projection regions of the two subcarrier boards 7 on the first plane, and the projections of the first heat dissipation portions 32 (such as the heat dissipation fin) of the first heatsink 3 on the first plane is located on the space at the left and right sides (perpendicular to the fluid inflow direction) outside the load region, and are located in the outer space of the projection region of the two subcarrier boards 7 on the first plane, so that the heat dissipation space of the power supply module group and the heat dissipation space of the two load groups are independent of each other, and separate heat dissipation is achieved, that is, on the plane perpendicular to the fluid inflow direction, the first heat dissipation portions 32 of the first heatsink 3 are located on the left and right sides of the second heatsink 4 without overlap. Therefore, the fluid flowing through the rear first heatsink 3 will not be preheated by the front load heatsink, and the temperature of the cooling medium remains low. Therefore, the first heatsink 3 has a strong heat dissipation capacity, which can effectively reduce the temperature of the power supply module group and meet the heat dissipation requirement of the power supply module group.

In some embodiments of the present application, the projection of the first heat dissipation portion 32 (such as the heat dissipation fin) of the first heatsink 3 on the first plane may be partially located in the projection region of the first carrier board on the first plane, but entirely located outside the load region. In this way, the first heatsink 3 is at least partially located within the maximum on-board heat dissipation space of the OAM module group, and the maximum on-board heat dissipation space cannot be totally used as the heat dissipation space of the load. The heat dissipation space of the load 1 is smaller than the maximum on-board heat dissipation space but larger than the heat dissipation space vertically above the load region. Compared with the embodiment in which the projection of the first heatsink on the first plane is entirely located outside the projection region of the first carrier board on the first plane, the area of the first heatsink 3 can be increased, and the heat dissipation capacity of the first heatsink 3 is relatively larger, but the heat dissipation capacity of the second heatsink 4 is relatively small. This implementation case is suitable for the situation where the load power consumption is large, the power supply module group loss is also large, and the load temperature and power supply temperature are both so high that it limits system performance.

In some other embodiments of the present application, the projection of the first heat dissipation portion 32 (such as the heat dissipation fin) of the first heatsink 3 on the first plane is partially located in the load region, and partially located outside the load region, so that the first heatsink 3 is not only located within the maximum on-board heat dissipation space of the OAM module group, but also its projection on the first plane is partially located in the load region, so that the heat dissipation space of the second heatsink 4 is smaller than the heat dissipation space vertically above the load region, but the heat dissipation area of the first heatsink 3 can be further expanded. Compared with the above two embodiments, the heat dissipation space of the load is the smallest, the heat dissipation capacity of the second heatsink 4 is the weakest, and the heat dissipation capacity of the first heatsink 3 is the strongest. This implementation case is suitable for the situation where the load power consumption is relatively small, the power supply module group loss is relatively large, and the power supply temperature is so high that it limits system performance.

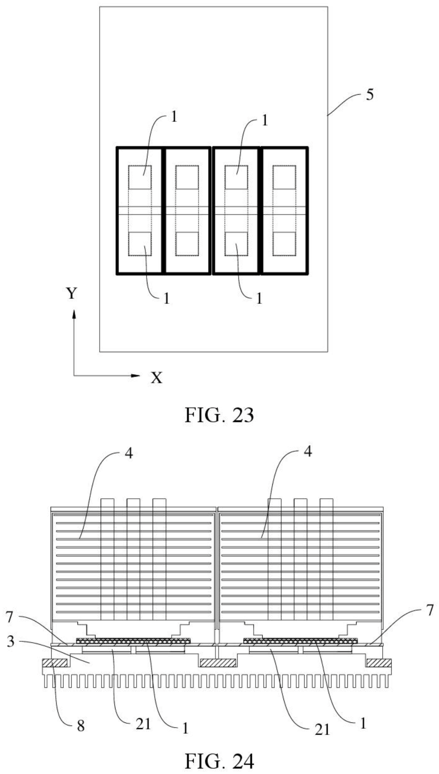

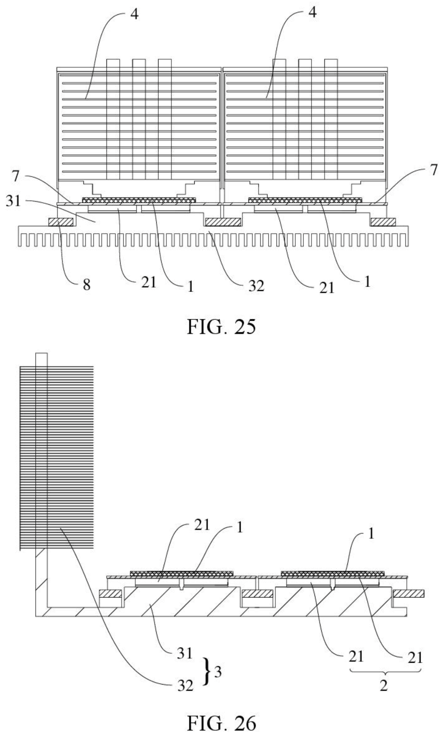

In some embodiments of the present application, the first heatsink 3 may set the first heat conduction portion 31 and the first heat dissipation portion 32 as one body, in this case, the first heatsink 3 is in direct contact with the lower surface of the power supply module group or through the thermal interface material, and the first heatsink 3 is thermally connected to the power supply module group. The first heatsink 3 may be arranged directly below the second carrier board 8, as shown in FIG. 24; or arranged directly below the second carrier board 8 and in the side space of the second carrier board 8, as shown in FIG. 25. In this way, while meeting the heat dissipation requirement, the installation process can be simplified and maintenance and module are convenient.

In some other embodiments of the present application, the second carrier board 8, the second heatsink 4, the reinforcing ribs, and the like can be excluded.

In some embodiments of the present application, one power supply module group includes at least one power supply submodule group 2, one power supply submodule group 2 includes at least one power supply module 21, and the first carrier board includes at least two subcarrier boards 7, the numbers of which are not limited. The power supply submodule group 2 is electrically connected to the load 1 through the subcarrier board 7 to supply power to the load 1.

In other embodiments, the first carrier board may also be omitted, and the power supply submodule group 2 is directly electrically connected to the load 1 to supply power to the load 1.

In some embodiments of the present application, the load group and the power supply module group can adopt a vertical power supply architecture, the main features of which are: the load 1 and the power supply submodule group 2 are stacked vertically directly or are stacked vertically through a carrier board, that is, in the direction perpendicular to the first plane, i.e., in the vertical direction, the load 1 is above or below the power supply submodule group 2; the projections of the power supply submodule group 2 and the load 1 on the first plane at least partially overlap, and the power transmission path between the load 1 and the power supply submodule group 2 is shortened as much as possible, thereby reducing the power delivery network (PDN) loss and improving the system power supply efficiency. Alternatively, there may be no overlap. In other embodiments of the present application, the load group and the power supply module group can also adopt a horizontal power supply architecture, that is, the load 1 and the power supply submodule group 2 are both arranged on the same plane or on the same surface of the first carrier board or the second carrier board 8.

In some embodiments, one load 1 (such as a GPU), a power supply submodule group 2 arranged below the load 1, a first subcarrier (such as an OAM board) connecting the load 1 and the power supply submodule group 2, and a load heatsink above the load 1 together constitute one OAM module group. Each data processing apparatus includes at least two OAM module groups, and the two OAM module groups share one first heatsink 3. In the server provided in the embodiment, the first heatsink 3 can dissipate heat for the power supply submodule groups 2 corresponding to at least two loads 1. Since at least part of the projection of the first heatsink 3 in the first plane is located outside the load region, the maximum on-board heat dissipation space of a single OAM module group is the space that is above the subcarrier board (OAM board) of the OAM module group and where the projection on the first plane overlaps with the projection of the subcarrier board (OAM board) on the first plane. The second heatsink 4 (load heatsink) is located in the maximum on-board heat dissipation space.

Taking the load group including two loads 1 as an example, as shown in FIG. 2, the dotted line box in FIG. 2 represents the first plane, and the load 1 includes an upper surface and a lower surface arranged oppositely to each other, where the upper surface of the load 1 is parallel to the first plane, and the lower surface of the load 1 is close to the power supply submodule group 2, and the region surrounded by the dotted line box is the load region. The region surrounded by each dotted line box can cover two loads 1. In this embodiment, the load region is defined as the minimum outer contour projection region of the load group that can cover all loads 1 in the first plane.

In some embodiments of the present application, the load 1 may include one or more of a graphics processing unit (GPU), a central processing unit (CPU), an embedded neural network processing unit (NPU), a data processing unit (DPU), an application-specific integrated circuit chip (ASIC), a field programmable gate array (FPGA), an accelerated processing unit (APU) or a tensor processing unit chip (TPU).

The types of the loads 1 in the load group may be at least partially the same or different.

In some embodiments of the present application, the power supply submodule group 2 includes at least one power supply module. Exemplarily, as shown in FIG. 1, the power supply submodule group 2 in the present embodiment includes two power supply modules 21, and the two power supply modules 21 supply power to the same load 1.

In some embodiments of the present application, the data processing apparatus may be an open computing accelerator module group, namely, an Open Computing Project (OCP) Accelerator Module.

In some embodiments of the present application, the power supply module group includes only one power supply submodule group 2, and the one power supply submodule group 2 supplies power to at least two loads 1 of the load group. The power supply submodule group 2 includes at least one power supply module 21.

In some embodiments of the present application, the first heatsink 3 may be a power supply module group heatsink for dissipating heat from the power supply module group, the second heatsink 4 may be a load heatsink for dissipating heat from the load 1, and the second carrier board 8 may be a system board.

In some embodiments of the present application, as shown in FIG. 1, the first heatsink 3 includes a first heat conduction portion 31 and a first heat dissipating portion 32, at least part of the first heat conduction portion 31 is arranged below the power supply module group, at least part of the first heat dissipating portion 32 is located outside the load region, and the first heat dissipating portion 32 is thermally connected to the first heat conduction portion 31. The thermal connection may refer to direct contact heat conduction connection, or indirect contact heat conduction connection through thermal interface material. The first heat conduction portion 31 may be partially embedded in the system support plate 20 (as shown in FIG. 4, FIG. 13, and FIG. 17), or can completely replace the system support plate 20 (as shown in FIG. 1). The system support plate 20 is located below the second carrier board 8 and is mechanically connected to the second carrier board 8 to play a structural support role and prevent the second carrier board 8 from bending and deforming. The system support plate 20 is a structural member with a certain strength and can be made of metal or non-metallic material.

In some embodiments of the present application, the first heat conduction portion 31 may be one of a heat pipe, a vapor chamber, a metal heat conduction plate and a non-metallic heat conduction structure, and the first heat conduction portion 31 may also include a combination of at least two of a heat pipe, a vapor chamber, a metal heat conduction plate and a non-metallic heat conduction structure. Among them, the metal heat conduction plate may be a copper plate, and the non-metallic heat dissipation structure may be a multi-layer graphite film or a multi-layer graphene thermal conductive film.

For example, as shown in FIG. 3, the first heat conduction portion 31 includes a vapor chamber 313 and a heat conduction plate 312. The heat conduction plate 312 includes a horizontal plate and a vertical plate. The horizontal plate is fixedly connected to the vertical plate and the horizontal plate is parallel to the plate surface of the load 1. The vapor chamber 313 is located between the horizontal plate and the power supply submodule group 2. The vapor chamber 313 is used to quickly diffuse and spread the heat of the power supply submodule group 2 to achieve the effect of equalizing the temperature and eliminating local hot spots. The heat conduction plate 312 is used to transfer the heat transferred from the power supply submodule group 2 to the vapor chamber 313 to the heat dissipation portion 32 through heat conduction, and then the cooling medium flows through the heat dissipation portion 32 to take away the heat. The heat conduction plate 312 is generally a metal plate, which relies on the metal's own thermal conductivity to achieve heat diffusion. For example, the thermal conductivity of the copper plate is 385W/(m·K), and the thermal conductivity of the aluminum alloy plate (6063 series) is 201W/(m·K). The vapor chamber 313 is a closed cavity made of metal. It is an efficient phase change heat transfer element fabricated by arranging a capillary structure in the metal cavity, vacuum pumping, and injecting liquid into the cavity. It has a stronger heat diffusion capability than the metal plate. For example, the equivalent thermal conductivity of a 2mm thick vapor chamber is 5000~20000W/(m·K). A portion of the first heat conduction portion 31 is located below the power supply submodule group 2, and the other portion is located above the power supply submodule group 2. For example, the vapor chamber 313 and the horizontal plate are located below the power supply submodule group 2, a portion of the vertical plate is located below the power supply submodule group 2, and the other portion of the vertical plate is located above the power supply submodule group 2; a portion of the projection of the first heat conduction portion 31 in the first plane is located outside the load region, and the other portion is located within the load region. It should be noted that the "above" and "below" referred to herein refer to the relative positional relationship in the height direction, rather than limiting the two structures to be within the same projection plane.

When there are multiple data processing apparatuses, each data processing apparatus can be configured with one small vapor chamber, or multiple data processing apparatuses can share the vapor chamber. The advantages of the small vapor chamber are smaller flatness and tolerance, lower contact thermal resistance between the vapor chamber and the power supply submodule group 2 after installation, better comprehensive heat transfer effect, more flexible configuration, and easier process implementation; the advantage of sharing a large vapor chamber is easier installation.

In some embodiments, the first heat dissipation portion 32 may be one of a heat dissipation fin, a liquid-cooled plate, a metal plate, and a non-metal heat dissipation structure, or a combination of at least two of the heat dissipation fin, liquid-cooled plate, metal plate, and non-metal heat dissipation structure. Among them, the metal plate may be a copper plate or an aluminum plate. It should be noted that the material of the first heat dissipation portion 32 may also be a composite material composed of diamond and copper, diamond and silver, and other materials or graphene.

In some embodiments, as shown in FIG. 3, the first heat dissipation portion 32 is a heat dissipation fin, which is connected to the vertical plate, and the heat of the power supply submodule group 2 is conducted to the heat dissipation fin through the temperature equalizing plate 313, the horizontal plate, and the vertical plate. Exemplarily, as shown in FIG. 3, the heat dissipation fin is located above the power supply submodule group 2, and the heat dissipation fin is located outside the load region.

In other embodiments, as shown in FIG. 4, the first heat dissipation portion 32 may be a cold plate, a flow channel is provided in the cold plate, and a circulating pump and a pipeline are provided outside to make the coolant circulate in the cold plate. The cold plate is used to dissipate heat from the power supply submodule group 2. Exemplarily, as shown in FIG. 4, in the height direction (indicated by the arrow direction Z), the cold plate is located below the power supply submodule group 2, a portion of the cold plate is located outside the load region, and the other portion is located in the load region, further increasing the heat dissipation area and improving the heat dissipation capacity.

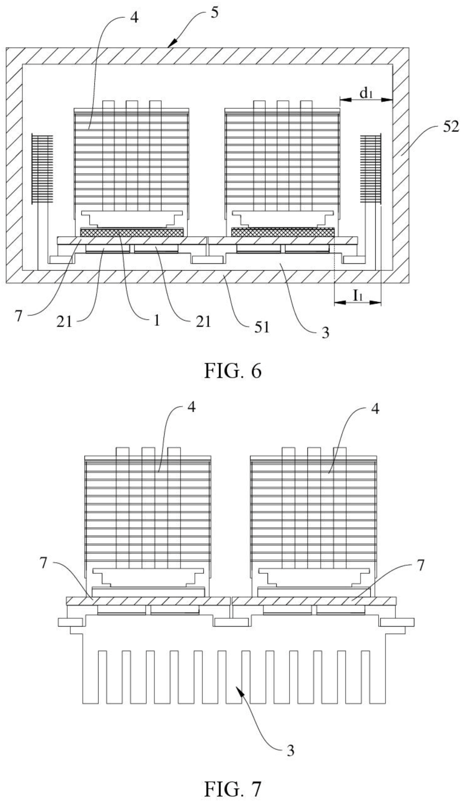

In some embodiments, as shown in FIG. 5 and FIG. 7, the first heatsink 3 is an integrally formed structure. The integrally formed first heatsink 3 may be the heat dissipation fin, liquid-cooled plate, vapor chamber, copper plate, aluminum plate, or a heat dissipation structure made of graphene, diamond and copper, or diamond and silver, and the thermal conductivity of the first heatsink 3 is not less than 45W/(m·K).

It should be understood that the server shown in FIG. 4, FIG. 5 and FIG. 26 may also include a second heatsink 4.

In other embodiments, as shown in FIG. 8, the first heatsink 3 includes multiple heat dissipation structures, and the multiple heat dissipation structures are connected. The multiple heat dissipation structures can be fixedly connected by welding or bonding, or can be riveted by rivets, or can be connected by fasteners such as bolts and nuts.

Exemplarily, the heat dissipation structure may be one or more of the heat dissipation fin, liquid-cooled plate, vapor chamber, copper plate, aluminum plate, a heat dissipation structure made of graphene material, a heat dissipation structure made of diamond and copper material, and a heat dissipation structure made of diamond and silver material. Specifically, the number of the heat dissipation structures is at least two. When the number of the heat dissipation structures is two, the two heat dissipation structures may be the same or different. When the number of the heat dissipation structures is three or more, all the heat dissipation structures may be one of the heat dissipation fin, liquid-cooled plate, vapor chamber, copper plate, aluminum plate, the heat dissipation structure made of graphene material, the heat dissipation structure made of diamond and copper material, and the heat dissipation structure made of diamond and silver material. Some heat dissipation structures may adopt the same structure, or all heat dissipation structures may adopt different structures.

In some other embodiments, the first heatsink 3 includes a first heat dissipation structure 3a and a second heat dissipation structure 3b (as shown in FIG. 8). The first heat dissipation structure 3a may be a vapor chamber, and the second heat dissipation structure 3b may be a heat dissipation fin.

In other embodiments, the first heatsink 3 may also be a wind scooper structure, and the power supply submodule group 2 is thermally connected to the wind scooper. Here, the thermal connection may be a connection between the wind scooper and the power supply submodule group 2 through a thermal interface material, so that heat is conducted from the power supply module group to the wind scooper through the thermal interface material. The thermal interface material can greatly reduce the contact thermal resistance between the power supply submodule group 2 and the wind scooper, thereby greatly improving the heat transfer efficiency. The thermal interface material may generally include materials such as silicone grease, thermally conductive gel, and thermally conductive pad. The wind scooper is arranged circumferentially around the power supply submodule group 2 perpendicular to the wind direction. The wind scooper structural part is fully utilized for heat dissipation. The wind scooper has both wind guiding and heat dissipation functions, and there is no need to set up an additional heatsink separately.

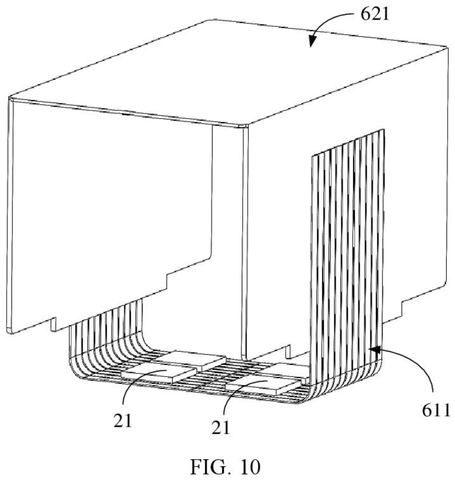

As shown in FIG. 10, the wind scooper structure includes a U-shaped heat pipe 611 and a U-shaped plate 621. The U-shaped heat pipe 611 is thermally connected to the power supply submodule group 2, and the U-shaped plate 621 is thermally connected to the U-shaped heat pipe 611. The U-shaped heat pipe 611 includes a horizontal section and two vertical sections, and the power supply submodule group 2 is installed on the horizontal section; the U-shaped heat pipe 611 is opposite to the opening of the U-shaped plate 621, and the two vertical sections are fixedly connected to the outer surfaces of the two side plates of the U-shaped plate 621.

The U-shaped heat pipe 611 is thermally connected to the power supply module 21, and the U-shaped plate 621 is thermally connected to the U-shaped heat pipe 611, which means that the heat of the power supply module can be transferred to the U-shaped heat pipe 611, and then transferred from the U-shaped heat pipe 611 to the U-shaped plate 621.

In one embodiment, at least 10% of the projection of the first heatsink 3 in the first plane is located outside the load region. The 10% of the projection here may refer to 10% of the projection area of the first heatsink 3 in the first plane, but considering the generally regular structure of the heatsink, and the actual heat dissipation effect and the convenience of illustration, the 10% of the projection here may also refer to 10% of the projection width of the first heatsink 3 in the first plane. As shown in FIG. 1, A is the width of the projection of the portion of the first heatsink 3 located outside the edge of one side of the load region in the first plane, and B is the width of the projection of the portion of the first heatsink 3 located outside the edge of the other side of the load region in the first plane, where A+B≥10% of the width of the projection of the first heatsink 3 in the first plane.

In this embodiment, the portion of the first heatsink 3 located outside the load region is distributed outside at least two edges of the load region. Exemplarily, the shape of the load region is rectangular, the load region has four edges, and the portion of the first heatsink 3 located outside the load region can be distributed outside at least two edges. When the width of one side cannot meet 10% of the width of the projection of the first heatsink 3 in the first plane due to structural limitations, the sum of the widths on both sides meets 10%, which can also ensure a certain heat dissipation area, thereby ensuring a certain heat dissipation capacity, and finally ensuring that the heat dissipation requirement of the power supply submodule group 2 is met.

As shown in FIG. 1, within the field of view, the portion of the first heatsink 3 located outside the load region is distributed on the left and right sides of the load region. The portion of the first heatsink 3 located outside the load region may also be distributed on the left and front sides of the load region, and may also be distributed at other positions outside the load region.

A thermal simulation analysis is performed on the model of 10% of the projection region of the first heatsink 3 distributed outside the load 1. Under the same heat consumption and air volume conditions, the temperature of the power supply submodule group 2 is 25°C lower than that in the case where the load and the power supply module group share the heat dissipation structure or the heat dissipation region space in the related art. And then the power supply submodule group 2 meets its temperature limit requirement. In the case that there is enough free space outside the load group, the first heatsink 3 is arranged as much as possible outside the load region, that is, when it is larger than or equal to 10% of the width of the projection of the first heatsink 3 in the first plane, the first heatsink 3 will have relatively good heat dissipation performance.

In one embodiment, the server further includes a housing 5 and a second heatsink 4. The second heatsink 4 is located above the load 1 and is used to dissipate heat from the load 1. The first heatsink 3, the second heatsink 4 and the load group are all located in the housing 5. At least part of the projection of the first heatsink 3 in the first plane is located outside the load region. The fluid flowing through the rear first heatsink will not be preheated by the front load heatsink, and the temperature of the cooling medium is kept low. Therefore, the first heatsink 3 has a strong heat dissipation capacity and can meet the heat dissipation requirement of the power supply submodule group 2, thereby effectively reducing the temperature of the power supply submodule group 2.

Since there is a certain height space at the bottom of the load group, it can be used to arrange the first heatsink 3. At the same time, the region between the side wall of the housing 5 and the second heatsink 4 is a region with a relatively large flow rate of the cooling medium. According to thermal simulation analysis, the flow rate of the cooling medium in the region between the side wall of the housing 5 and the second heatsink 4 is about 5.5 m/s, while the flow rate at other positions is about 2.6 m/s. Arranging the first heatsink 3 as much as possible in the region with a relatively large flow rate is conducive to further reducing the temperature of the power supply submodule group 2. In particular, a thermal simulation analysis is performed on a model in which 10% of the first heatsink 3 is distributed in the projection region outside the load 1. Under the same heat consumption and air volume conditions, the temperature of the power supply submodule group 2 is 25°C lower than that in the case where the load and the power supply submodule group share a heat dissipation structure or heat dissipation region space in the related art, and the power supply submodule group 2 meets its temperature limit requirement.

In some embodiments of the present application, in the projection in the first plane, at least part of the first heatsink 3 is located between the side wall of the housing 5 and the side wall of the second heatsink 4 arranged opposite to the side wall of the housing, and the width of the part of the first heatsink 3 located between the side wall of the housing and the side wall of the second heatsink 4 is at least 10% of the distance between the side wall of the second heatsink 4 and the side wall of the housing 5.

For example, as shown in FIG. 6, the housing 5 includes a right side wall 52 and a bottom plate 51, and at least part of the first heatsink 3 is located between the right side wall 52 of the housing 5 and the side wall of the second heatsink 4 close to the right side wall 52, and the side wall of the second heatsink 4 is arranged opposite to the right side wall 52 of the housing 5.

Exemplarily, the side wall of the second heatsink 4 is parallel to the right side wall 52 of the housing 5, the width of the part of the first heatsink 3 between the right side wall 52 of the housing 5 and the side wall of the second heatsink 4 is I₁, the distance between the side wall of the second heatsink 4 and the right side wall 52 of the housing 5 is d₁, and I₁≥10%d₁.

Since the region between the side wall of the housing and the second heatsink 4 close to the side wall of the housing is a region with a large flow rate of the cooling medium, at least part of the first heatsink 3 is arranged between at least one side wall of the housing and the second heatsink 4, and there is a vertical plane perpendicular to the bottom plate 51 of the housing. The vertical plane intersects with both the first heatsink 3 and the two second heatsinks 4. On this vertical plane, the common wind speed design inside the chassis is adopted, and thermal simulation analysis is performed on the model of I₁=10%d₁. Under the same heat consumption and air volume conditions, the temperature of the power supply submodule group 2 is 25°C lower than the case where the load and the power supply submodule group share the heat dissipation structure or heat dissipation region space in the related art, and the power supply submodule group 2 meets its temperature limit requirement.

It should be noted that when the side wall of the second heatsink 4 is not parallel to the right side wall 52 of the housing 5, d₁ is the minimum distance between the side wall of the second heatsink 4 and the right side wall 52 of the housing 5.

In one embodiment, at least part of the first heatsink 3 is in contact with the housing 5. As shown in FIG. 6, the surface of the first heatsink 3 close to the bottom plate 51 of the housing is in contact with the bottom plate 51 of the housing 5, which can increase the heat dissipation path, and the heat of the power supply module group is dissipated to the outside of the server through the first heatsink 3 and the housing 5, further reducing the temperature of the power supply submodule group 2, thereby further improving the power transmission efficiency of the power supply submodule group 2.

In one embodiment, as shown in FIG. 9, third heatsinks 6 are provided on both sides of the second heatsink 4. The third heatsink 6 includes a third heat conduction portion 61 and a third heat dissipation portion 62, the third heat conduction portion 61 is thermally connected to the power supply submodule group 2, the third heat dissipation portion 62 is thermally connected to the third heat conduction portion 61, and at least part of the projection of the third heatsink 6 in the first plane is located in the load region.

By setting the third heatsinks 6, the heat dissipation path of the power supply submodule group 2 can be increased, which can be used to dissipate heat for the power supply submodule group 2 with a relatively high power consumption. In this embodiment, the heat of the power supply submodule group 2 can be dissipated not only through the first heatsinks 3, but also through the third heatsinks 6.

The third heat conduction portion 61 may be one or a combination of at least two of an integrated bent vapor chamber, a common heat pipe, an ultra-thin array heat pipe, a copper plate, an aluminum plate, diamond and copper, diamond and silver, graphene, etc., and the third heat dissipation portion 62 may be a metal shovel-tooth heatsink, a snap-on heatsink, a copper plate, an aluminum plate, a liquid-cooled plate, diamond and copper, diamond and silver, graphene, and other heat dissipation mechanism.

The third heat conduction portion 61 and the third heat dissipation portion 62 may be integrally formed or separately formed.

In this embodiment, the first heatsink 3 and the third heatsink 6 can share part of the heat conduction portion, that is, a part of the first heat conduction portion 31 and a part of the third heat conduction portion 61 are attached or integrally arranged.

In some embodiments, the third heatsink 6 is a wind scooper structure, the power supply submodule group 2 is thermally connected to the wind scooper, and the wind scooper is arranged around the circumference of the power supply submodule group 2.

For example, as shown in FIGs. 9 and 10, the third heat conduction portion 61 includes a U-shaped heat pipe 611, the U-shaped heat pipe 611 includes a horizontal section and two vertical sections, and the power supply submodule group 2 is installed on the horizontal section. The third heat dissipation portion 62 includes a U-shaped plate 621, the U-shaped heat pipe 611 is opposite to the opening of the U-shaped plate 621, and the two vertical sections are respectively fixedly connected to the outer surfaces of the two side plates of the U-shaped plate 621, and the U-shaped plate 621 and the U-shaped heat pipe 611 together form a wind scooper structure.

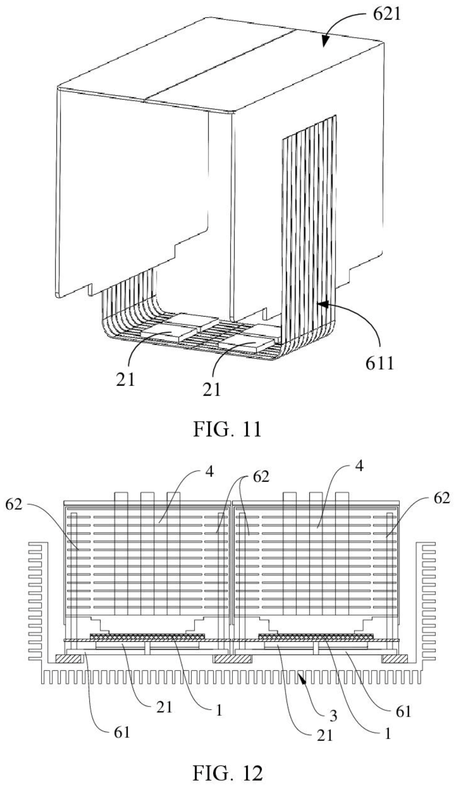

For example, as shown in FIG. 11, the U-shaped plate 621 is a split structure, for example, the U-shaped plate 621 includes two L-shaped plates arranged oppositely; for another example, as shown in FIG. 10, the U-shaped plate 621 is an integrated structure.

In the field of view shown in FIG. 9, the wind scooper being arranged around the circumference of the power supply submodule group 2 means that the wind scooper is arranged around the power supply submodule group 2 in four directions of up, down, left, and right to enhance the heat dissipation effect.

It should be noted that, as shown in FIG. 12, the third heatsink 6 may also be a 3DVC (i.e., three dimensional vapor chamber, Three Dimensional Vapor Chamber) heatsink. The 3DVC heatsink includes a third heat conduction portion 61 and a third heat dissipation portion 62.

In some embodiments of the present application, the data processing apparatus further includes a first carrier board, and the power supply submodule group 2 supplies power to the load 1 through the first carrier board; at least part of the first heatsink 3 is located on the side of the power supply submodule group 2 away from the first carrier board.

As shown in FIG. 9, in one possible design, the first carrier board is arranged between the load 1 and the power supply submodule group 2. At this time, the data processing apparatus is a vertical power supply structure, a part of the first heatsink 3 is located on the side of the power supply submodule group 2 away from the first carrier board, and the other part is located on the side of the power supply submodule group 2 close to the first carrier board, and the power supply submodule group 2 and the load 1 overlap at least partially in the direction perpendicular to the first carrier board.

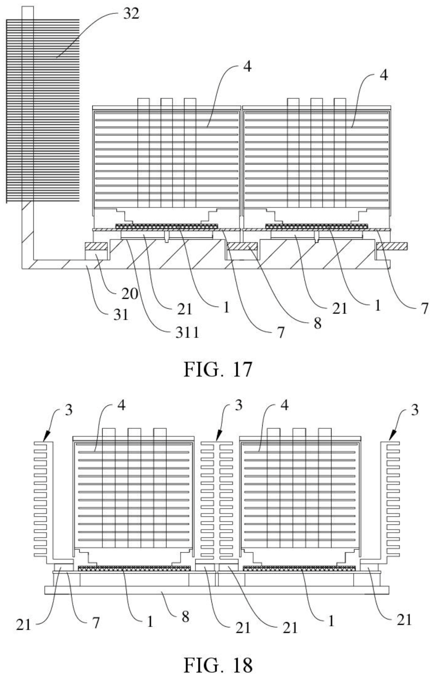

In another possible design, as shown in FIG. 18, the load 1 and the power supply submodule group 2 are both arranged on the same side of the first carrier board. At this time, the data processing apparatus is a horizontal power supply structure, and the first heatsink 3 is entirely located on the side of the power supply submodule group 2 away from the first carrier board, that is, all located above the power supply submodule group 2.

In this embodiment, the first carrier board may be a Printed Circuit Board (PCB) board, a Direct Bond Copper (DBC) board, etc., or an Open Computing Project (OCP) Accelerator Module (OAM) board.

In some embodiments, one load 1 (such as a GPU), a power supply submodule group 2 disposed below the load 1, a first subcarrier (such as an OAM board) connecting the load 1 and the power supply submodule group 2, a load heatsink above the load 1, etc. together constitute one OAM module group. Each data processing apparatus includes at least two OAM module groups.

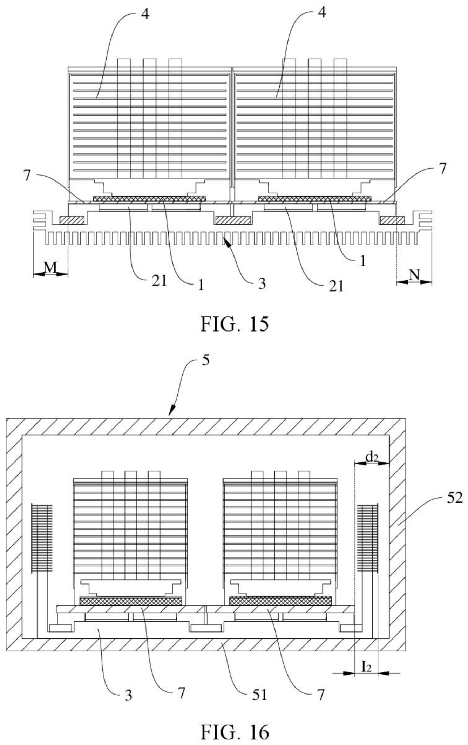

As shown in FIG. 15, in one embodiment, the projection region of the first carrier board in the horizontal plane is larger than the load region, and at least part of the projection of the first heatsink 3 in the first plane is located between the load region and the projection region of the first carrier board in the first plane.

For the low-power consumption load 1 and liquid-cooled heat dissipation solution, the minimum size of the projection of the second heatsink 4 in the first plane may be designed to be the size of the load region. At this time, the first heatsink 3 can be arranged in the space within the projection region of the first carrier board and outside the load region, so that the arrangement of the first heatsink 3 is simple and flexible, and the process is simplified.

In other embodiments, at least part of the projection of the first heatsink 3 in the first plane may also be located outside the projection region of the first carrier board in the first plane. It is applicable to the case where the load 1 has a relatively high power consumption, and more heat dissipation space can be created for the load 1, for example, the space above the first carrier board is all used for the load heatsink, which improves the heat dissipation effect of the load 1, thereby improving the computing power performance of the load 1, and further improving the performance of the server. At least part of the projection of the first heatsink 3 in the first plane is outside the projection region of the first carrier board, and the load 1 and the power supply submodule group 2 are separately dissipated, and the heat dissipation capacity of the load heatsink and the heat dissipation capacity of the power supply submodule group heatsink do not conflict. In addition, the fluid here will not be preheated by the front load heatsink, and the temperature of the cooling medium is relatively low. Therefore, the first heatsink 3 has a strong heat dissipation capacity, which makes the temperature of the power supply submodule group 2 lower and can meet its heat dissipation requirement.

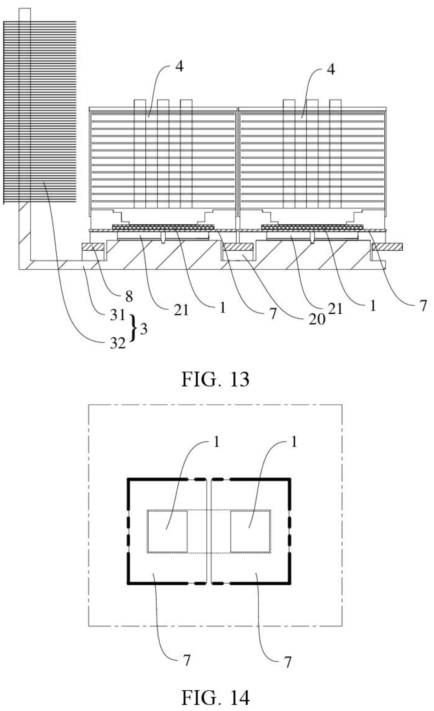

In one embodiment, as shown in FIG. 13, the first carrier board includes at least two subcarrier boards 7, and the at least two subcarrier boards 7 are respectively connected to at least two loads 1 in the load group. The projection region of the first carrier board in the first plane is the minimum outer contour projection region of the first carrier board that can cover all subcarrier boards 7 in the first plane.

The two subcarrier boards 7 can be separately provided or integrally provided.

As shown in FIG. 14, taking the first carrier board including two subcarrier boards 7 as an example, the thick double-dotted dashed box in FIG. 14 is the projection region of the first carrier board in the first plane. For the convenience of description, the projection region of the first carrier board in the first plane is referred to as the carrier board region.

In one embodiment, at least 10% of the projection of the first heatsink 3 in the first plane is located outside the carrier board region. As shown in FIG. 15, M is the width of the projection of the first heatsink 3 located outside the edge of one side of the carrier board region in the first plane, and N is the width of the projection of the first heatsink 3 located outside the edge of the other side of the carrier board region in the first plane, where M+N≥10% of the width of the projection of the first heatsink 3 in the first plane. A thermal simulation analysis is performed on the model in which 10% of the first heatsink 3 is distributed in the projection region outside the first carrier board. Under the same heat consumption and air volume conditions, the temperature of the power supply submodule group 2 is 25°C lower than the case in which the load and the power supply module group share the heat dissipation structure or heat dissipation region space in the related art, and the power supply submodule group 2 meets its temperature limit requirement.

As shown in FIG. 15, within the field of view, the portion of the first heatsink 3 located outside the carrier board region is distributed on the left and right sides of the carrier board region. The portion of the first heatsink 3 located outside the carrier board region may also be distributed on the left and front sides of the carrier board region, and may also be distributed at other positions outside the carrier board region.

It should be understood that the projection of the first heatsink 3 in the first plane may also be completely located in the carrier board region.

In one embodiment, as shown in FIG. 16, the server also includes a housing 5, at least part of the first heatsink 3 is located between the housing 5 and the edge of the first carrier board, and the width of the part of the first heatsink 3 located between the housing 5 and the edge of the first carrier board is at least 10% of the distance between the edge of the first carrier board and the side wall of the housing 5 arranged opposite to the edge.

Exemplarily, as shown in FIG. 16, the first carrier board includes a right edge, the housing 5 includes a right side wall 52 and a bottom plate 51, the right side wall 52 is arranged opposite to the right edge, and at least part of the first heatsink 3 is located between the right edge of the first carrier board and the right side wall of the housing 5.

Exemplarily, the right edge of the first carrier board is parallel to the right side wall of the housing 5, the width of the part of the first heatsink 3 that is located between the right edge of the first carrier board and the right side wall of the housing 5 is I₂, the distance between the right edge of the first carrier board and the right side wall of the housing 5 is d₂, and I₂≥10% d₂.

When the right edge of the first carrier board is not parallel to the right side wall of the housing 5, d₂ is the minimum distance between the right edge of the first carrier board and the right side wall of the housing 5.

In some embodiments, as shown in FIG. 17, the server further includes a second carrier board 8, the second carrier board 8 is located below the first carrier board, and at least part of the first heatsink 3 is located above the second carrier board 8.

By setting the second carrier board 8, the electrical connection of multiple loads 1 inside the data processing apparatus and the electrical connection of multiple power supply submodule groups 2 can be realized.

As shown in FIG. 17, a part of the first heatsink 3 is located above the second carrier board 8, the first heatsink 3 includes a first heat conduction portion 31, the second carrier board 8 is provided with a first through hole, the first heat conduction portion 31 includes a first protrusion 311, and the first protrusion 311 is inserted in the first through hole to conduct heat from the power supply submodule group 2. The first heatsink 3 also includes a first heat dissipation portion 32. In the height direction (indicated by the arrow direction Z), the first heat dissipation portion 32 is located above the second carrier board 8, and the projection of the first heat dissipation portion 32 in the first plane is not necessarily all located in the projection region of the second carrier board 8 in the first plane. As shown in FIG. 17, the projection of the first heat dissipation portion 32 in the first plane can be all located outside the projection region of the second carrier board 8 in the first plane.

As shown in FIG. 18, the first heatsink 3 is entirely located above the second carrier board 8. At this time, the data processing apparatus is a horizontal power supply architecture. It should be noted that the "above" and "below" referred to in the present disclosure refer to the relative position relationship in the height direction, rather than limiting the two structures to be in the same projection plane.

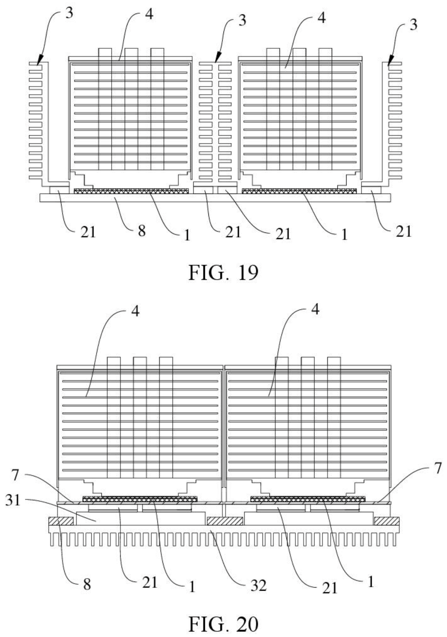

In other embodiments, as shown in FIG. 20, the first heat dissipation portion 32 of the first heatsink 3 is located below the first heat conduction portion 31, and the first heat dissipation portion 32 is entirely disposed below the second carrier board 8. In this way, the space between the second carrier board 8 and the bottom plate 51 of the housing can be fully utilized for heat dissipation, and the heat dissipation requirement of the power supply submodule group 2 can be met. There is no need to arrange the power supply module group heatsink between the second carrier board 8 and the side wall of the housing, which is conducive to reducing the size of the server in the width direction, where the width direction is consistent with the arrangement direction of the two loads 1.

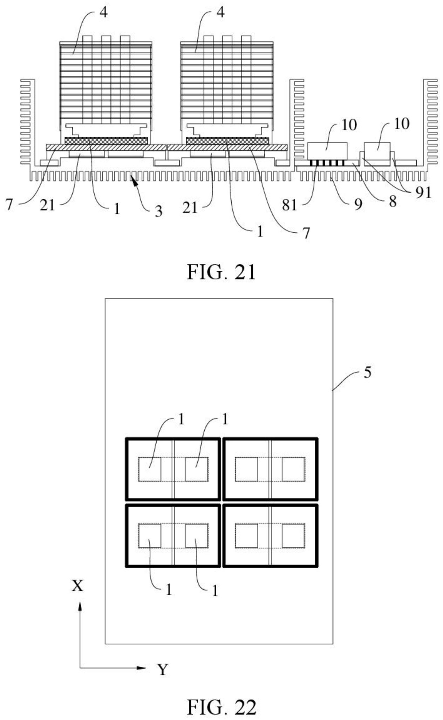

In one embodiment, as shown in FIG. 21, the server further includes an additional heat source 10, which is disposed on the second carrier board 8. While the first heatsink 3 dissipates heat for the power supply submodule group 2, it can also dissipate heat for the additional heat source 10.

The additional heat source 10 may include a control module group, a power supply module group, a Peripheral Component Interconnect Express (PCIE) processor, an Expansion Card module (EXP) module group, etc. Since the bottom space of the server can be used to arrange the first heatsink 3, and the second carrier board 8 is arranged above at least part of the first heatsink 3, the heat source on the second carrier board 8, such as the power supply submodule group 2, can directly contact the first heatsink 3 for heat dissipation. For the heat source that cannot directly contact the first heatsink 3, a fourth heatsink 9 can be provided. The fourth heatsink 9 is arranged on the upper side of the second carrier board 8. For example, the fourth heatsink 9 may be arranged above the additional heat source 10 and contact the additional heat source 10 to dissipate heat for the additional heat source 10.

The fourth heatsink 9 may also be arranged on the side of the second carrier board 8 away from the additional heat source 10, the second carrier board 8 is provided with a second through hole, the fourth heatsink 9 includes a second protrusion 91, the second protrusion 91 is inserted in the second through hole and is thermally connected to the additional heat source 10. The second carrier board 8 is provided with a third through hole, a heat conduction column 81 is provided in the third through hole, and the additional heat source 10 is thermally connected to the fourth heatsink 9 through the heat conduction column 81.

In other embodiments, the second through hole and the third through hole can also be set alternatively.

It should be noted that a via may also be directly set on the second carrier board 8, and a third protrusion is set on the side of the first heatsink 3 close to the second carrier board 8. The third protrusion extends from the via to the side of the additional heat source 10, contacts with the additional heat source 10 and dissipates heat.

In one embodiment, as shown in FIG. 19, for a horizontal power supply architecture, the server may also include a second carrier board 8 and omit the first carrier board, thereby shortening the signal transmission path and improving the signal transmission rate and efficiency. At this time, the load 1 and the power supply submodule group 2 are both arranged on the same side of the second carrier board 8, and the first heatsink 3 is located above the power supply submodule group 2.

It should be understood that in the height direction, the first heatsink 3 is located above the second carrier board 8, and the projection of the first heatsink 3 in the first plane is not necessarily all located within the projection of the second carrier board 8 in the first plane.

In this embodiment, at least part of the first heatsink 3 is located between the housing 5 and the edge of the second carrier board 8, and the width of the part of the first heatsink 3 located between the housing 5 and the edge of the second carrier board 8 is at least 10% of the distance between the edge of the second carrier board 8 and the side wall of the housing 5 arranged opposite to the edge.

In one embodiment, the number of data processing apparatuses is at least two, at least two data processing apparatuses are arranged along the first direction, and at least two loads 1 in the load group in each data processing apparatus are arranged along the second direction. The first direction is perpendicular to the second direction, and the first direction and the second direction are both parallel to the first plane. In this embodiment, the first direction and the second direction are both perpendicular to the height direction of the server, and one of the first direction and the second direction is the length direction of the server, and the other is the width direction of the server.

In a possible design, as shown in FIG. 22, the arrow direction X indicates the first direction, the arrow direction Y indicates the second direction, the thick solid line box indicates the data processing apparatus, the dotted line box indicates the load group in the data processing apparatus, and the number of data processing apparatuses is four. Within the field of view, the two data processing apparatuses on the left are arranged along the first direction, and the load groups in the two data processing apparatuses on the left each include two loads 1, and the two loads 1 are arranged along the second direction.

Since at least part of the projection of the first heatsink 3 in the first plane is located outside the load region, the power supply submodule group 2 and the load 1 can be separated for heat dissipation, thereby ensuring that the heat of the power supply submodule group 2 in the data processing apparatus in the front row is transferred from the outside of the data processing apparatus to the data processing apparatus in the back row alone, and the temperature of the air that flows into the first heatsink 3 in the data processing apparatus in the back row is low, so that the heat dissipation capacity of the first heatsink 3 in the back row is stronger, thereby ensuring that the temperature of the power supply submodule group 2 of the data processing apparatus in the back row is lower, and avoiding the problem of uneven current and unstable power supply caused by excessive temperature difference between the power supply submodule groups 2 of the data processing apparatuses in the front and back rows. The data processing apparatus in the front row refers to the data processing apparatus located below within the field of view.

In another possible design, as shown in FIG. 23, the arrow direction X represents the first direction, the arrow direction Y represents the second direction, the thick solid line box represents the data processing apparatus, the dotted line box represents the load group in the data processing apparatus, the number of data processing apparatuses is four, the four data processing apparatuses are arranged along the first direction, and the load group in each data processing apparatus includes two loads 1, and the two loads 1 are arranged along the second direction.

It should be understood that when the number of data processing apparatuses is more than three, all data processing apparatuses can be all arranged along the first direction, or at least two of the data processing apparatuses can be arranged along the first direction, and the remaining data processing apparatus(es) can be arranged along the second direction with any one of the two data processing apparatuses.

As shown in FIG. 26, the server provided in this embodiment may not be provided with the second carrier board 8 and the second heatsink 4. Specifically, the server may include a data processing apparatus and a first heatsink 3, the data processing apparatus includes a load group and a power supply module group, the load group includes at least two loads 1, and the power supply module group supplies power to the load group; the first heatsink 3 is thermally connected to the power supply module group, and at least part of the projection of the first heatsink 3 in the first plane is located outside the load region, where the load 1 includes an upper surface and a lower surface arranged oppositely, the first plane is parallel to the upper surface of the load, and the load region is the minimum outer contour projection region of the load group in the first plane that can cover all loads.

Through the server provided in this embodiment, the first heatsink can dissipate heat for the power supply module group corresponding to at least two loads. Since at least part of the projection of the first heatsink in the first plane is located outside the load region, the power supply module group and the load can be separate for dissipation, and the first heatsink does not occupy the heat dissipation space of the load, ensuring a good heat dissipation effect of the load, thereby ensuring the computing power performance of the load, and further improving the performance of the server. At the same time, at least part of the projection of the first heatsink in the first plane is located outside the load region, and the fluid flowing through the rear first heatsink will not be preheated by the front load heatsink, and the temperature of the cooling medium remains low. Therefore, the first heatsink has a strong heat dissipation capacity, meets the heat dissipation requirement of the power supply module group, and effectively reduces the temperature of the power supply module group.

Finally, it should be noted that the above embodiments are only used to illustrate the technical solutions of the present disclosure, rather than to limit them. Although the present disclosure is described in detail with reference to the above embodiments, those skilled in the art should understand that they can still modify the technical solutions recorded in the above embodiments, or replace some or all of the technical features therein by equivalent; and these modifications or replacements do not make the essence of the corresponding technical solutions deviate from the scope of the technical solutions of the embodiments of the present disclosure.

## Claims

1. A server, comprising: a data processing apparatus and a first heatsink (3), wherein the data processing apparatus comprises a load group and a power supply module group, the load group comprises at least two loads (1), and the power supply module group supplies power to the load group; the first heatsink (3) is thermally connected to the power supply module group, at least part of a projection of the first heatsink (3) in a first plane is located outside a load region, wherein the load (1) comprises an upper surface and a lower surface arranged oppositely, the first plane is parallel to the upper surface of the load (1), and the load region is a minimum outer contour projection region of the load group that can cover all the loads (1) in the first plane.

2. The server according to claim 1, wherein at least 10% of the projection of the first heatsink (3) in the first plane is located outside the load region,
or
wherein the part of the first heatsink (3) located outside the load region is distributed outside at least two edges of the load region.

3. The server according to claim 1 or 2, further comprising a housing (5) and a second heatsink (4), wherein the second heatsink (4) is located above the load (1) and is used to dissipate heat from the load (1); the first heatsink (3), the second heatsink (4) and the load group are all located in the housing; in the projection of the first plane, at least part of the first heatsink (3) is located between a side wall of the housing (5) and a side wall of the second heatsink (4) arranged opposite to the side wall of the housing (5), and a width of the part of the first heatsink (3) located between the side wall of the housing (5) and the side wall of the second heatsink (4) is at least 10% of a distance between the side wall of the second heatsink (4) and the side wall of the housing (5).

4. The server according to claim 3, wherein at least part of the first heatsink (3) is in contact with the housing (5).

5. The server according to claim 3, wherein the power supply module group comprises at least one power supply submodule group (2), and a third heatsink (6) is provided on both sides of the second heatsink (4), the third heatsink (6) comprises a third heat conduction portion (61) and a third heat dissipation portion (62), the third heat conduction portion (61) is thermally connected to the power supply submodule group (2), the third heat dissipation portion (62) is thermally connected to the third heat conduction portion (61), and at least part of a projection of the third heatsink (6) in the first plane is located in the load region.

6. The server according to claim 1 or 2, wherein the data processing apparatus further comprises a first carrier board, and the power supply module group supplies power to the load group through the first carrier board;
the first carrier board is arranged between the load group and the power supply module group, or the load group and the power supply module group are arranged on a same side of the first carrier board;
at least part of the first heatsink (3) is located at a side of the power supply module group away from the first carrier board.

7. The server according to claim 6, wherein a projection region of the first carrier board in the first plane is larger than the load region, and at least part of the projection of the first heatsink (3) in the first plane is located between the load region and the projection region of the first carrier board in the first plane; or, at least part of the projection of the first heatsink (3) in the first plane is located outside the projection region of the first carrier board in the first plane.

8. The server according to claim 6, wherein the first carrier board comprises at least two subcarrier boards (7), the at least two subcarrier boards (7) are respectively connected to the at least two loads (1) in the load group, the power supply module group comprises at least two power supply submodule groups (2), the at least two power supply submodule groups (2) are respectively connected to the at least two subcarrier boards (7), and a projection region of the first carrier board in the first plane is a minimum outer contour projection region of the first carrier board that can cover all the subcarrier boards (7) in the first plane.

9. The server according to claim 6, further comprising a housing (5), wherein at least part of the first heatsink (3) is located between the housing (5) and an edge of the first carrier board, and a width of the part of the first heatsink (3) located between the housing (5) and the edge of the first carrier board is at least 10% of a distance between the edge of the first carrier board and a side wall of the housing (5) arranged opposite to the edge.

10. The server according to claim 6, further comprising a second carrier board (8), wherein the second carrier board (8) is located below the first carrier board, and at least part of the first heatsink (3) is located above the second carrier board (8), and the server further comprises an additional heat source (10) and a fourth heatsink (9), wherein the additional heat source (10) is arranged on the second carrier board (8), wherein:
the second carrier board (8) is provided with a second through hole, the fourth heatsink (9) comprises a second protrusion, and the second protrusion is inserted in the second through hole and is thermally connected to the additional heat source (10);
and/or, the second carrier board (8) is provided with a third through hole, a heat conduction column (81) is arranged in the third through hole, and the additional heat source (10) is thermally connected to the fourth heatsink (9) through the heat conduction column (81).

11. The server according to claim 1 or 2, further comprising a second carrier board (8), wherein the load group and the power supply module group are both arranged on a same side of the second carrier board (8), and the first heatsink (3) is located above the power supply module group.

12. The server according to claim 1 or 2, wherein the power supply module group comprises at least one power supply submodule group (2), the first heatsink (3) comprises a first heat conduction portion (31) and a first heat dissipation portion (32), at least part of the first heat conduction portion (31) is arranged below the power supply module group, at least part of the first heat dissipation portion (32) is located outside the load region, and the first heat dissipation portion (32) is thermally connected to the first heat conduction portion (31), and the first heat conduction portion (31) comprises one or more of a heat pipe, a vapor chamber, a metal heat conduction plate, and a non-metallic heat conduction structure, or the first heat dissipation portion (32) comprises one or more of a heat dissipation fin, a liquid-cooled plate, a metal plate and a non-metallic heat dissipation structure.

13. The server according to claim 1 or 2, wherein the first heatsink (3) is an integrated structure, or the first heatsink (3) comprises multiple heat dissipation structures, and the multiple heat dissipation structures are connected,
or, wherein the load (1) comprises one or more of a GPU, a CPU, a NPU, a DPU, an ASIC, an FPGA, an APU or a TPU, or the data processing apparatus is an OAM.

14. The server according to claim 1 or 2, wherein a number of the data processing apparatus is at least two, the at least two data processing apparatuses are arranged along a first direction, the at least two loads (1) in the load group in each of the data processing apparatuses are arranged along a second direction, the first direction is perpendicular to the second direction, and the first direction and the second direction are both parallel to the first plane.

15. The server according to claim 1 or 2, wherein the power supply module group comprises at least one power supply submodule group (2), and the power supply submodule group (2) comprises at least one power supply module (21).
